# EUROPEAN PATENT APPLICATION

(11) **EP 4 654 193 A1**
(43) Date of publication of application: **26.11.2025**
(21) Application number: 24749637.5
(22) Date of filing: 26.01.2024
(51) Int. Cl.: G11C 8/10, G06F 12/02

(54) **DECODING METHOD, FIRST DIE, AND SECOND DIE**

(30) Priority: 31.01.2023 CN 202310116104
(71) Applicant: Huawei Technologies Co., Ltd., Shenzhen, Guangdong 518129 (CN)
(72) Inventor: LIU, Kang, Shenzhen, Guangdong 518129 (CN); ZHENG, Jintao, Shenzhen, Guangdong 518129 (CN); ZHANG, Jun, Shenzhen, Guangdong 518129 (CN)
(74) Representative: Isarpatent
(86) International application number: PCT/CN2024/074317
(87) International publication number: WO 2024/160156

(57) **Abstract**

Embodiments of this application provide a decoding method, a first die, and a second die, and relate to the field of chip technologies, to reduce configuration information of the first die. A specific solution is: The first die determines, based on first address space information and first address information carried in a first access request, whether the first access request is used to access the first die (701). If the first die determines that the first access request is not used to access the first die, the first die performs decoding based on the first address information to obtain a die identifier of the second die, and sends a second access request to the second die, where the second access request includes the first address information and the die identifier of the second die, and the second access request is used for decoding by the second die to obtain a module identifier of a functional module, in the second die, to be accessed by using the first access request (702). Embodiments of this application are used in a process in which a plurality of functional modules access each other.

## Description

This application claims priority to Chinese Patent Application No. 202310116104.8, filed with the China National Intellectual Property Administration on January 31, 2023 and entitled "DECODING METHOD, FIRST DIE, AND SECOND DIE", which is incorporated herein by reference in its entirety.

### TECHNICAL FIELD

Embodiments of this application relate to the field of chip technologies, and in particular, to a decoding method, a first die, and a second die.

### BACKGROUND

For a chip to which a chiplet (chiplet) technology is applied, a chiplet includes various functional modules, such as a processor core (core), an accelerator, and a double data rate synchronous dynamic random-access memory (double data rate synchronous dynamic random-access memory, DDR SDRAM). Various functional modules are connected through a bus. The bus may be of a structure such as a ring (ring), a mesh (mesh), or a crossbar or crossbar switch matrix (crossbar).

Mutual access between the functional modules is implemented in a "request-response" handshake manner. A request of the functional module passes through a decoding node before entering the bus. The decoding node translates an address in the request based on a mapping relationship between the address and a destination module, to provide address information of the corresponding destination module, and provide a basis for bus routing.

With emergence of the chiplet technology, a plurality of dies (dies) with different functions are combined into one chip. Due to a great difference in structures between the dies and a strong requirement for a complex topology and flexible expansion, more address segments are obtained through division in the chip. That is, configuration information increases. A table lookup process of decoding is increasingly complex as the configuration information increases, and a higher requirement is imposed on design of decoding.

### SUMMARY

Embodiments of this application provide a decoding method, a first die, and a second die. In a hierarchical decoding manner, the first die is only configured with address space information of a module of the first die and address space information of another die, to reduce configuration information of the first die and reduce decoding complexity.

To achieve the foregoing objectives, the following technical solutions are used in embodiments of this application.

According to a first aspect, an embodiment of this application provides a decoding method. The decoding method is applied to a first die. The first die includes a plurality of functional modules. The first die is configured with first address space information. The first address space information includes address space information of each functional module in the first die and address space information of another die other than the first die. The method includes: The first die determines, based on the first address space information and first address information carried in a first access request, whether the first access request is used to access the first die. If the first die determines that the first access request is not used to access the first die, the first die performs decoding based on the first address information to obtain a die identifier of a second die, and sends a second access request to the second die. The second access request includes the first address information and the die identifier of the second die, and the second access request is used for decoding by the second die to obtain a module identifier of a functional module, in the second die, to be accessed by using the first access request.

Therefore, the first die is only configured with the address space information of each functional module in the first die and the address space information of the another die without configuration of address space information of each functional module in the another die, so that configuration information of the first die can be reduced, and a circuit area of a decoding node can be reduced. In addition, the first die uses a hierarchical decoding manner, and before the first access request enters a bus, whether the first access request is used to access the first die is first determined. If the first access request is not used to access the first die, the first die obtains the die identifier of the second die based on the first address information carried in the first access request, and the second die obtains, through decoding, the module identifier of the functional module to be accessed by using the first access request. Hierarchical decoding is different from a conventional technology in which the first die obtains, based on the first address information, a complete identifier of the functional module to be accessed by using the first access request in that decoding complexity is reduced, which facilitates timing convergence of decoding. In addition, during design of each die, only an architecture of a die connected to the first die needs to be paid attention to, without a need to pay attention to an internal topological structure of the connected die, to simplify a design requirement for multi-die interconnection, and implement flexible extension of decoding in any die-interconnection structure. In addition, for different connected dies, there is no need to design different decoding principles, so that feasibility of die sharing can be ensured.

In a possible design, the method further includes: If the first die determines that the first access request is used to access the first die, the first die performs decoding based on the first address information to obtain a module identifier of a functional module, in the first die, to be accessed by using the first access request.

In this design, because the first die is configured with the address space information of each functional module, if the first access request is used to access the first die, the first die obtains, through decoding, complete chip identifier, die identifier, and module identifier that correspond to the first address information, to complete mutual access between the functional modules in the first die.

In a possible design, the address space information of each functional module in the first die includes a base address of each functional module in the first die and an address space size of each functional module in the first die, and the address space information of the another die includes a base address of the another die and an address space size of the another die.

In this design, the address space information of the functional module may be understood as an address range, and the address space information of the another die may also be understood as an address range. In the first die, address space only needs to be allocated to the another die, and address space does not need to be allocated to a functional module in the another die. In this way, the configuration information of the first die is reduced, and a reserved window is used for cross-die interconnection, without a need to pay attention to the internal topological structure of the connected die, to simplify the design requirement for multi-die interconnection, and implement flexible extension of decoding in any die-interconnection structure.

In a possible design, the first address information is used for decoding to obtain a chip identifier, a die identifier, and the module identifier that correspond to the functional module to be accessed by using the first access request.

In this design, a process of performing decoding based on the first address information to obtain the chip identifier, the die identifier, and the module identifier that correspond to the functional module is essentially a table lookup process. The first address information corresponds to an address in the first address space information, and a functional module corresponding to the address may be determined, to determine the chip identifier, the die identifier, and the module identifier that correspond to the functional module.

In a possible design, determining, by the first die based on the first address space information and the first address information carried in the first access request, whether the first access request is used to access the first die includes: When the first die determines that the first address information is within an address range of the address space information of the another die, determining, by the first die, that the first access request is not used to access the first die; or when the first die determines that the first address information is within an address range of the address space information of the functional module in the first die, determining, by the first die, that the first access request is used to access the first die.

In this design, before first decoding, the first die first performs address matching, and determines whether the first address information corresponds to the address range of the another die or the address range of the functional module, to determine whether the first access request is used to access the first die. For the first access request used to access the first die, a first decoding node obtains the complete identifier of the functional module through decoding. For the first access request not used to access the first die, the first decoding node obtains only the chip identifier and the die identifier through decoding. In this way, decoding complexity is reduced, which facilitates decoding timing convergence.

According to a second aspect, an embodiment of this application provides a decoding method. The decoding method is applied to a second die, and the method includes: The second die receives a second access request sent by a first die, where the second access request includes first address information and a die identifier obtained by the first die through decoding. When the second die determines that the die identifier is a die identifier of the second die, the second die performs decoding based on the first address information to obtain a module identifier of a functional module, in the second die, to be accessed by using the second access request.

In this design, before second decoding is performed on a cross-die interface of the second die, it is first determined whether the die identifier obtained by the first die through decoding in the second access request is the identifier of the second die. If the die identifier is the die identifier of the second die, second decoding is performed on the cross-die interface of the second die. In this way, a decoding node at the second die only needs to be configured with address space information of the second die and address space information of another die, so that configuration information of each decoding node can be greatly reduced, and a circuit area required for decoding is reduced. In addition, through hierarchical decoding, decoding complexity is also reduced, which facilitates timing convergence of decoding.

In a possible design, the method further includes: When the second die determines that the die identifier is not the die identifier of the second die, the second die transmits the second access request to a third die.

In this design, for the access request not used to access the second die, the second die transparently transmits the second access request to the third die without performing decoding. In this way, a quantity of times of decoding can be reduced, and transmission efficiency of the access request can be provided.

In a possible design, the second die includes a plurality of functional modules, the second die is configured with second address space information, and the second address space information includes address space information of each functional module in the second die and the address space information of the another die other than the second die.

In this design, either the first die or the second die in a chip system is only configured with address space information of functional modules in the current die and address space information of another die, so that configuration information of the first die and the second die can be reduced, and a circuit area related to the decoding node can be reduced.

In a possible design, the address space information of each functional module in the second die includes a base address of each functional module in the second die and an address space size of each functional module in the second die, and the address space information of the another die includes a base address of the another die and an address space size of the another die.

According to a third aspect, an embodiment of this application provides a first die. The first die includes a plurality of functional modules. The first die is configured with first address space information. The first address space information includes address space information of each functional module in the first die and address space information of another die other than the first die. The first die further includes: a determining unit, configured to determine, based on the first address space information and first address information carried in a first access request, whether the first access request is used to access the first die; and a first decoding unit, configured to: if the first die determines that the first access request is not used to access the first die, perform decoding based on the first address information to obtain a die identifier of a second die, and send a second access request to the second die. The second access request includes the first address information and the die identifier of the second die, and the second access request is used for decoding by the second die to obtain a module identifier of a functional module, in the second die, to be accessed by using the first access request.

For beneficial effects of the third aspect, refer to the descriptions of the first aspect.

In a possible design, the first decoding unit is further configured by the first die to: if the first die determines that the first access request is used to access the first die, perform decoding based on the first address information to obtain a module identifier of a functional module, in the first die, to be accessed by using the first access request.

In a possible design, the address space information of each functional module in the first die includes a base address of each functional module in the first die and an address space size of each functional module in the first die, and the address space information of the another die includes a base address of the another die and an address space size of the another die.

In a possible design, the first address information is used for decoding to obtain a chip identifier, a die identifier, and the module identifier that correspond to the functional module to be accessed by using the first access request.

In a possible design, the determining unit is further configured to: when the first die determines that the first address information is within an address range of the address space information of the another die, determine that the first access request is not used to access the first die; or when the first die determines that the first address information is within an address range of the address space information of the functional module in the first die, determine that the first access request is used to access the first die.

According to a fourth aspect, an embodiment of this application provides a second die. The second die includes a receiving unit, configured to receive a second access request sent by a first die, where the second access request includes first address information and a die identifier obtained by the first die through decoding; and a second decoding unit, configured to: when the second die determines that the die identifier is a die identifier of the second die, perform decoding based on the first address information to obtain a module identifier of a functional module, in the second die, to be accessed by using the second access request.

For beneficial effects of the fourth aspect, refer to the descriptions of the second aspect.

In a possible design, the second die further includes: a transmission unit, configured to: when the second die determines that the die identifier is not the die identifier of the second die, transmit the second access request to a third die.

In a possible design, the second die includes a plurality of functional modules, the second die is configured with second address space information, and the second address space information includes address space information of each functional module in the second die and address space information of another die other than the second die.

In a possible design, the address space information of each functional module in the second die includes a base address of each functional module in the second die and an address space size of each functional module in the second die, and the address space information of the another die includes a base address of the another die and an address space size of the another die.

According to a fifth aspect, an embodiment of this application provides a computer-readable storage medium, including computer instructions. When the computer instructions are run on an electronic device, the electronic device is enabled to perform the decoding method according to any one of the foregoing aspects and the possible implementations.

According to a sixth aspect, an embodiment of this application provides a computer program product. When the computer program product runs on a computer or a processor, the computer or the processor is enabled to perform the decoding method according to any one of the foregoing aspects and the possible implementations.

It may be understood that any first die, second die, computer-readable storage medium, computer program product, or the like provided above may be used in the corresponding method provided above. Therefore, for beneficial effects that can be achieved by the first die, second die, computer-readable storage medium, computer program product, or the like, refer to the beneficial effects in the corresponding method. Details are not described herein again.

These aspects or other aspects in this application are more concise and comprehensible in the following descriptions.

### BRIEF DESCRIPTION OF DRAWINGS

FIG. 1 is a diagram of a structure of a chip system according to an embodiment of this application;
FIG. 2 is a schematic of topological structures of different buses according to an embodiment of this application;
FIG. 3 is a diagram of a structure of a chip system in which mutual access is performed based on a ring bus according to an embodiment of this application;
FIG. 4 is a diagram of a structure of an execution device according to an embodiment of this application;
FIG. 5 is a diagram of address space configuration of a first decoding node according to an embodiment of this application;
FIG. 6 is a diagram of a structure of another chip system according to an embodiment of this application;
FIG. 7 is a flowchart of a decoding method according to an embodiment of this application;
FIG. 8 is a flowchart of another decoding method according to an embodiment of this application;
FIG. 9 is a flowchart of processing an access request by a first die according to an embodiment of this application;
FIG. 10 is a flowchart of another decoding method according to an embodiment of this application;
FIG. 11 is a flowchart of processing an access request by a second die according to an embodiment of this application;
FIG. 12 is another flowchart of processing an access request by a second die according to an embodiment of this application;
FIG. 13 is a diagram of address space configuration of a first decoding node and a second decoding node according to an embodiment of this application;
FIG. 14 is a possible composition diagram of a first die according to an embodiment of this application; and
FIG. 15 is a possible composition diagram of a second die according to an embodiment of this application.

### DESCRIPTION OF EMBODIMENTS

For ease of understanding, some concepts related to embodiments of this application are described for reference by using examples. Details are as follows.

An interposer (interposer): The interposer is a silicon interposer. Logic chips placed on the interposer are connected through a through-silicon via (through-silicon via, TSV) with microelectrodes.

Mesh bus (mesh bus): All functional modules in the mesh bus are connected to each other. Each functional module is connected to at least two other functional modules. All the functional modules form an entire chip system.

Ring bus (ring bus): The ring bus includes four independent "rings": a data ring, a request ring, a response ring, and a listening ring. Each node in each "ring" can receive 32-byte data in each clock cycle. This division mode enables automatic selection of a shortest path for "ring" access constantly, to shorten a latency.

Crossbar (crossbar): A physical connection between a functional module and a switching structure in a crossbar bus is simplified as a point-to-point connection, and this can ensure stability of data transmission. In addition, a plurality of functional modules connected to the crossbar bus can transmit data at the same time, and this can improve efficiency of data transmission.

The following describes the technical solutions in embodiments of this application with reference to the accompanying drawings in embodiments of this application. In description in embodiments of this application, "/" means "or" unless otherwise specified. For example, A/B may represent A or B. In this specification, "and/or" describes only an association relationship for describing associated objects and represents that three relationships may exist. For example, A and/or B may represent the following three cases: Only A exists, both A and B exist, and only B exists. In addition, in the descriptions in embodiments of this application, "a plurality of" means two or more.

The terms "first" and "second" mentioned below are merely intended for a purpose of description, and shall not be understood as an indication or implication of relative importance or implicit indication of the number of indicated technical features. Therefore, a feature limited by "first" or "second" may explicitly or implicitly include one or more features. In the description of embodiments, unless otherwise specified, "a plurality of" means two or more.

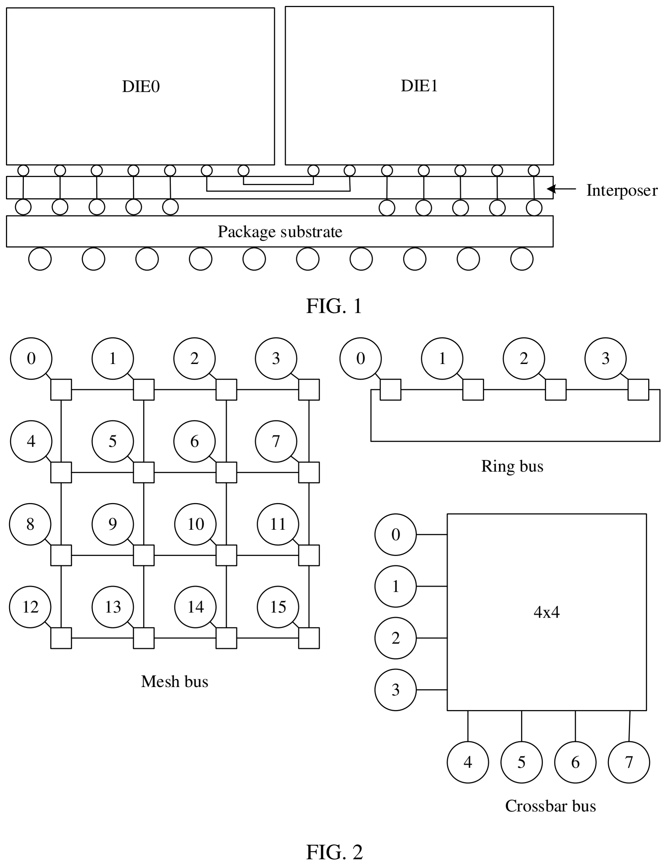

As a process evolves, one of solutions in the industry is to use a chiplet technology to maintain the Moore's law. The chiplet technology is a technology in which a plurality of different wafers or dies (dies) are packaged in a chip (chip) by using a TSV packaging technology, to complete a function of a complex chip through a combination of different dies. A chip structure using the TSV packaging technology is referred to as a chiplet architecture. FIG. 1 is a diagram of a structure of a chip system according to an embodiment of this application. The chip system may include DIEO and DIE1. DIEO may be a logic (logic) die, and DIE1 may be a high-bandwidth memory (high bandwidth memory, HBM). DIEO and DIE1 are coupled to each other by using an interposer (interposer) and a substrate (substrate), to form the chip system.

For the chip system, the chip system includes various functional modules, such as a core, an accelerator, and a DDR SDRAM. The various functional modules are connected through a bus. FIG. 2 is a schematic of topological structures of different buses according to an embodiment of this application. FIG. 2 shows a schematic of topological structures of a mesh bus, a ring bus, and a crossbar bus. For the mesh bus, the bus is connected to 16 functional modules in total, which are a functional module 0 to a functional module 15, and a topological structure of the mesh bus is a 4x4 mesh structure. For the ring bus, the bus is connected to four functional modules in total, which are a functional module 0 to a functional module 3. All the functional modules in the ring bus are mounted on the ring bus, and interaction between the functional modules is convenient and flexible, without a need for processor transfer. The crossbar bus is also referred to as the crossbar bus. The bus is connected to eight functional modules in total, which are a functional module 0 to a functional module 7.

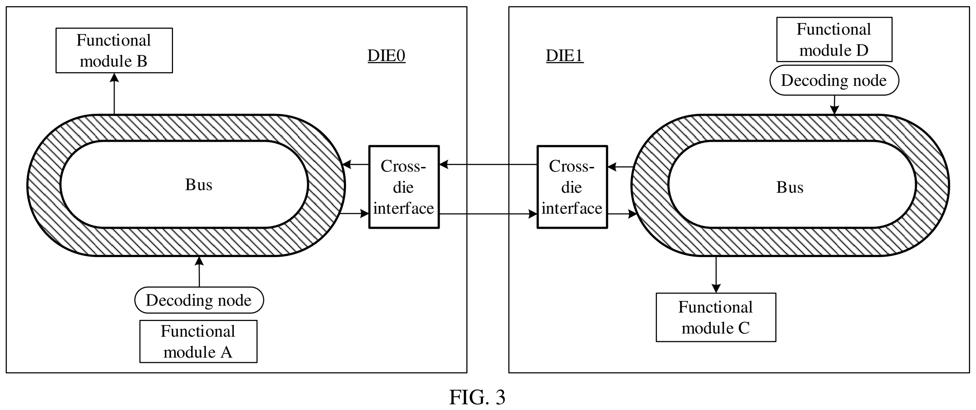

Mutual access between the functional modules is implemented in a "request-response" handshake manner. To implement a flexible topological structure between the functional modules, address space information of an entire chip system needs to be obtained, but each functional module on the bus cannot be obtained. FIG. 3 is a diagram of a structure of a chip system in which mutual access is performed based on a ring bus according to an embodiment of this application. The chip system includes DIE1 and DIE0. DIEO includes a functional module A and a functional module B. DIE1 includes a functional module C and a functional module D. DIEO and DIE1 are coupled through a cross-die interface. For example, the functional module D requests to access the functional module A. First, the functional module D sends an access request, and carries address information of the functional module A. The access request passes through a decoding node before entering the bus. The decoding node determines, based on the address information, that the address information corresponds to the functional module A, and attaches a destination node identifier (target identity document, tgtid) of the functional module A to the request. Then, the access request enters the bus, enters a bus of DIEO through the cross-die interface between DIEO and the DIE1, and reaches the functional module A. After receiving the access request, the functional module A returns a response or data. Therefore, a process of accessing the functional module A by the functional module D ends.

It should be noted that, to reduce routing difficulty, the bus determines a routing path of a packet by using tgtid. tgtid includes a chip identifier (socket identity document, sktid), a die identifier (die identity document, dieid), and a module identifier (port identity document, portid). sktid is a chip identifier of a chip in which a destination node is located, dieid is a die identifier of a die in which the destination node is located, and portid is a module identifier of a functional module in which the destination node is located. In a process in which the functional module D requests to access the functional module A, the bus of DIE1 identifies that sktid is a current chip, but dieid is not the current die, and sends the request to the cross-die interface, so that the request reaches a destination die. A bus of DIEO then sends the request to the functional module A by using portid.

In short, decoding is a process of translating an address in an access request based on a mapping relationship between address information and a functional module, to obtain corresponding tgtid, and provide a basis for bus routing. The mapping relationship is shown in Table 1. Each window is configured with a base address, an address space size (size), and tgtid. An address range may be determined based on the base address and the address space size. For an address falling into the address range, corresponding tgtid of the address is tgtid configured for that window. In a system-on-chip (system-on-chip, SoC), an address window is configured for each address. A process of decoding the access request is essentially a table lookup process.

**Table 1 Mapping relationship between an address and a module**

| Window | Base address | Size | tgtid |
|---|---|---|---|
| Window 0 | addr_A | 2 G | Module A |
| Window 1 | addr_B | 4 G | Module B |
| Window 2 | addr_C | 8 G | Module C |
| Window 3 | addr_D | 16 G | Module D |
| ... | ... | ... | ... |

Currently, on-chip decoding is usually implemented based on a non-hierarchical principle. That is, each decoding node may obtain a topological structure of the entire chip system. However, a complex topological structure causes an increase in configuration information of the decoding node, and all the configuration information needs to be stored and calculated. As a result, area overheads of a circuit increases. In addition, due to limited resource planning of the decoding node, the non-hierarchical principle in turn limits expansion space and reduces flexibility of a complex topology. For example, during design, each decoding node has 32 windows, and each die requires eight windows. In this case, the chip system supports interconnection of a maximum of four dies. In addition, during development of different dies, a structure of a possible connected die needs to be considered, to design a decoding principle accordingly. As a result, development of different dies cannot be decoupled, and there is a restriction on each other. This limits a possibility of sharing the dies in different projects.

Therefore, an embodiment of this application provides a decoding method. The decoding method is applied to a first die in a chip system. The following first describes the chip system.

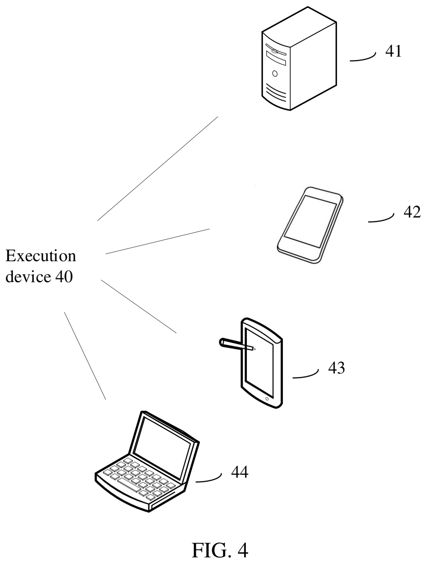

The chip system (chiplet system) may be applied to different devices, for example, applied to an execution device 40 shown in FIG. 4. FIG. 4 is a diagram of a structure of an execution device according to an embodiment of this application. The execution device 40 may be a terminal, for example, a server 41, a mobile phone terminal 42, a tablet computer 43, a notebook computer 44, an augmented reality (augmented reality, AR) device (not shown in FIG. 4), a virtual reality (virtual reality, VR) device (not shown in FIG. 4), or a vehicle-mounted terminal (not shown in FIG. 4).

The chip system includes a plurality of dies (dies) that have specific functions and that can be modularized and assembled with each other. For example, the die may implement functions such as data storage, computation, signal processing, and data stream management. Based on a rich intellectual property core (intellectual property core, IP) reserve, the chiplet system proposes a concept of "IP as a chiplet" (IP as a chiplet, IaaC), to realize, by using the dies, "plug-and-play" of an IP with a special function. For example, for some core processor IPs, the dies may be a graphics processing unit (graphics processing unit, GPU) IP, a neural-network processing unit (neural-network unit, NPU) IP, a video processing unit (video processing unit, VPU) IP, a digital signal processor (digital signal processing, DSP) IP, an image signal processor (image signal processor, ISP) IP, a display processor IP, and the like. In addition, the die may alternatively be a digital-analog hybrid IP, a radio frequency IP, and the like.

The chiplet system in this application may also be referred to as a chip system or a chiplet system. In other words, the die may also be referred to as a small chip or a chiplet.

For example, the chiplet system may be applied to system-on-a-chip (system-on-a-chip, SoC), and dies with a plurality of functions are integrated on the SoC. For example, the chip system includes the first die provided in this embodiment of this application. The first die includes a plurality of functional modules, for example, a functional module A and a functional module B. The functional modules may be a core, an accelerator, a DDR SDRAM, and the like.

The first die is configured with first address space information, and the first address space information includes address space information of each functional module in the first die and address space information of another die other than the first die.

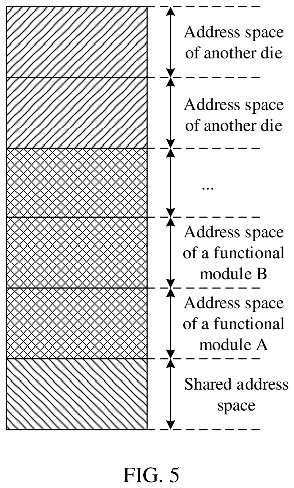

For example, the first die may include a first decoding node, and the first decoding node is configured with first address space information. The first decoding node may be implemented by using hardware. For example, the first decoding node may be a group of logic circuits with multi-input and multi-output. In an example, FIG. 5 is a diagram of address space configuration of a first decoding node according to an embodiment of this application. Each segment of address space corresponds to one decoding window. Shared address space is address space for storing a functional module shared by each die due to a configuration requirement of a chip system. Address space of a functional module A is address space allocated to the functional module A, address space of a functional module B is address space allocated to the functional module B, and address space of another die is address space allocated to the another die. The another die may be a second die, a third die, or the like.

When address space of the first decoding node of the first die is configured, first, a segment of address space is configured for each die in the chip system. Then, for address space corresponding to the first die, address space of each functional module is further configured. Therefore, an address space configuration manner of the first decoding node in this embodiment of this application is different from a conventional technology in which address space of each functional module in the chip system is configured for each decoding node in that only the address space of each functional module in the first die and the address space of the another die are configured, and address space of a functional module in the another die is not configured, so that configuration information of the decoding node can be reduced, and a circuit area occupied by the decoding node can be reduced.

An embodiment of this application provides a decoding method. A first die uses a hierarchical decoding manner, and before a first access request enters a bus, whether the first access request is used to access the first die is first determined. If the first access request is not used to access the first die, the first die obtains a die identifier of a second die based on first address information carried in the first access request, and the second die obtains, through decoding, a module identifier of a functional module to be accessed by using the first access request. Hierarchical decoding is different from a conventional technology in which the first die obtains, based on the first address information, a complete identifier of the functional module to be accessed by using the first access request in that decoding complexity is reduced, which facilitates timing convergence of decoding. In addition, during design of each die, only an architecture of a die connected to the first die needs to be paid attention to, without a need to pay attention to an internal topological structure of the connected die, to simplify a design requirement for multi-die interconnection, and implement flexible extension of decoding in any die-interconnection structure. In addition, for different connected dies, there is no need to design different decoding principles, so that feasibility of die sharing can be ensured.

The following first describes a specific chip system to which the decoding method provided in this embodiment of this application is applied.

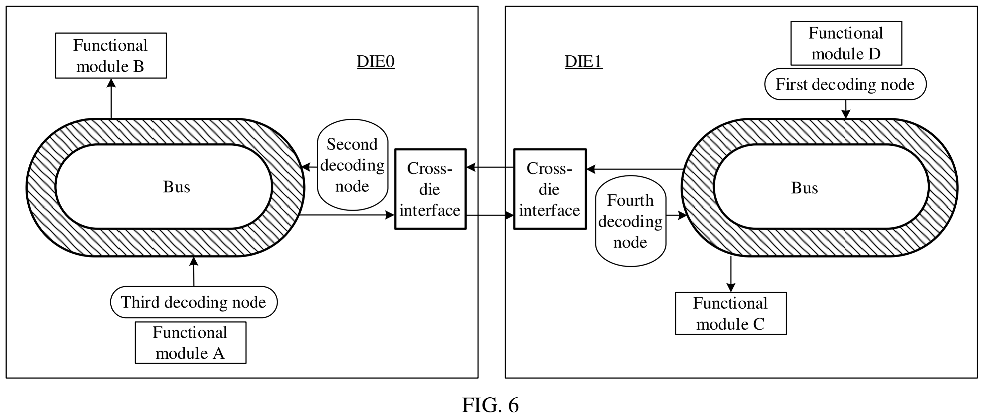

The chip system provided in this embodiment of this application is different from that in the conventional technology in that a level-1 decoding node is added at a cross-die interface of the die. FIG. 6 is a diagram of a structure of another chip system according to an embodiment of this application. FIG. 6 shows two dies: DIEO and DIE1. DIEO includes a functional module A and a functional module B. DIE1 includes a functional module C and a functional module D. DIEO and DIE1 are coupled through a cross-die interface. In addition, DIE1 further includes a first decoding node and a fourth decoding node, where the first decoding node is provided between the functional module D and a bus, and the fourth decoding node is provided between the cross-die interface and the bus. DIEO further includes a second decoding node and a third decoding node, where the second decoding node is provided between the cross-die interface and the bus, and the third decoding node is provided between the functional module A and the bus.

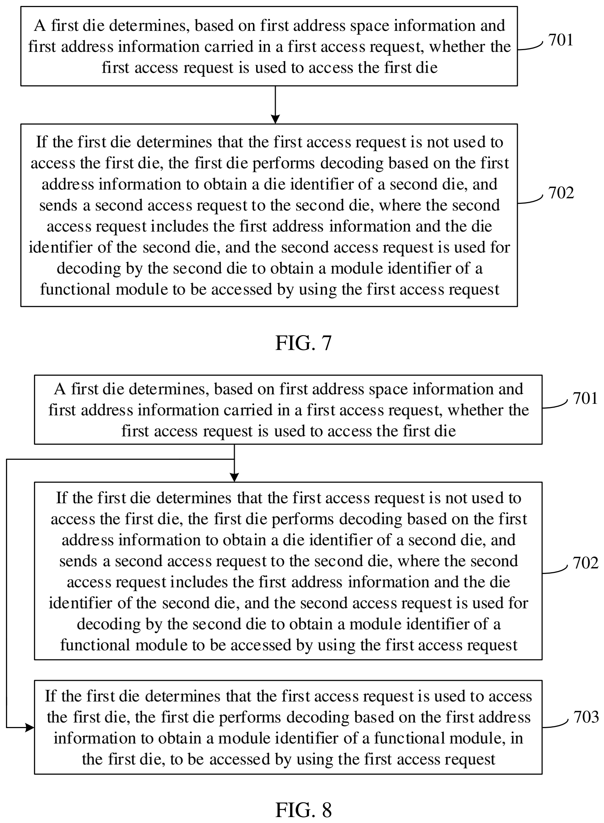

An embodiment of this application provides a decoding method applied to the chip system shown in FIG. 6. As shown in FIG. 7, FIG. 7 is a flowchart of a decoding method according to an embodiment of this application. The method includes the following procedure.

Step 701: A first die determines, based on first address space information and first address information carried in a first access request, whether the first access request is used to access the first die.

For example, when address space of a first decoding node of the first die is configured, only address space information of each functional module in the first die and address space information of another die are configured. Therefore, before the first access request enters a bus, the first decoding node determines whether the first access request is used to access the first die. If the first access request is used to access the first die, that is, the first access request is that a functional module in the first die accesses a functional module in the first die, the first decoding node should determine, based on the first address information carried in the first access request, address space information of the functional module to be accessed by using the first access request, to complete access between the functional modules in the first die. If the first access request is not used to access the first die, that is, the first access request is that a functional module in the first die accesses a functional module in the another die, the first decoding node should determine, based on the first address information carried in the first access request, the address space information of the another die to be accessed by using the first access request, to complete a process of sending the first access request to the another die.

The address space information of each functional module in the first die includes a base address of each functional module in the first die and an address space size of each functional module in the first die, and the address space information of the another die includes a base address of the another die and an address space size of the another die.

For example, the address space information of the functional module may be understood as an address range. That is, the address space is an address range that starts from the base address and whose size is the address space size. Similarly, the address space information of the another die may also be understood as an address range.

It should be noted that the address space size of each functional module is irrelevant to the address space size of the another die, and may be obtained through division based on an address space size required by each functional module.

Step 702: If the first die determines that the first access request is not used to access the first die, the first die performs decoding based on the first address information to obtain a die identifier of a second die, and sends a second access request to the second die, where the second access request includes the first address information and the die identifier of the second die, and the second access request is used for decoding by the second die to obtain a module identifier of a functional module, in the second die, to be accessed by using the first access request.

The first address information is used for decoding to obtain a chip identifier, a die identifier, and the module identifier that correspond to the functional module to be accessed by using the first access request.

For example, a process of performing decoding based on the first address information to obtain the chip identifier, the die identifier, and the module identifier that correspond to the functional module is essentially a table lookup process. The first address information corresponds to an address in the first address space information, and a functional module corresponding to the address may be determined, to determine the chip identifier, the die identifier, and the module identifier that correspond to the functional module.

For example, if the first address information corresponds to an address in address space of the another die, the first die may determine that the first access request is not used to access the first die. Because the first decoding node is only configured with the address space information of the another die without configuration of address space information of each functional module in the another die, only the die identifier of the second die can be obtained through decoding by the first decoding node. The first die sends the second access request to a cross-die interface between the second die and the first die through the bus. In this case, the second access request carries the first address information and the die identifier of the second die, so that a second decoding node at the second die decodes the first address information again, to obtain the module identifier of the functional module, in the second die, to be accessed by using the first access request.

Therefore, in a hierarchical decoding manner provided in this embodiment of this application, based on a hierarchical decoding principle, each decoding node only needs to be configured with address space information of each die and address space information of each functional module in a current die, so that configuration information of each decoding node can be greatly reduced, and a circuit area required for decoding is reduced. In addition, through hierarchical decoding, decoding complexity is also reduced, which facilitates timing convergence of decoding. In addition, during design of each die, only an architecture of a die connected to the first die needs to be paid attention to, without a need to pay attention to an internal topological structure of the connected die, to simplify a design requirement for multi-die interconnection, and implement flexible extension of decoding in any die-interconnection structure. In addition, for different connected dies, there is no need to design different decoding principles, so that feasibility of die sharing can be ensured.

Optionally, FIG. 8 is a flowchart of another decoding method according to an embodiment of this application. The method may further include step 703.

Step 703: If the first die determines that the first access request is used to access the first die, the first die performs decoding based on the first address information to obtain a module identifier of a functional module, in the first die, to be accessed by using the first access request.

For example, if the first address information corresponds to an address in address space of the functional module in the first die, the first die may determine that the first access request is used to access the first die. Because the first decoding node is configured with the address space information of each functional module in the first die, the first decoding node may perform decoding based on the first address information to obtain a chip identifier, a die identifier, and the module identifier of the functional module, in the first die, to be accessed by using the first access request. In this case, the chip identifier of the functional module is a chip identifier of a chip in which the first die is located, and the die identifier of the functional module is a die identifier of the first die.

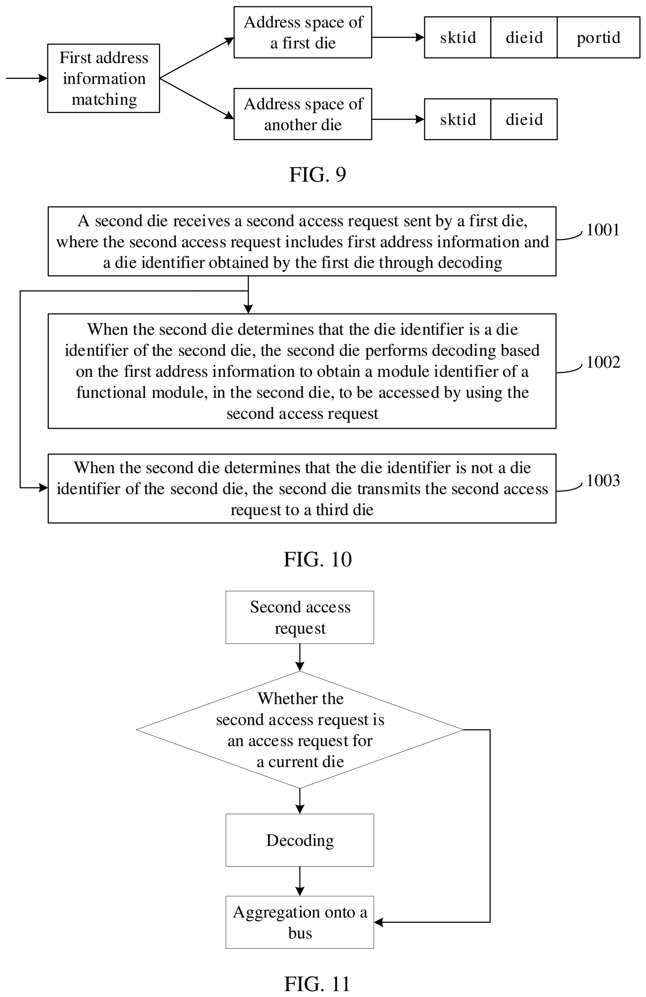

With reference to step 701 to step 703, it may be understood that a procedure for the first decoding node is shown in FIG. 9. FIG. 9 is a flowchart of processing an access request by a first die according to an embodiment of this application. The procedure may include: The first die performs first address information matching. If first address information corresponds to address space of a functional module in the first die, the first decoding node performs decoding to obtain complete tgtid of a functional module to be accessed by using a first access request, that is, obtain sktid, dieid, and a portid. If the first address information corresponds to address space of another die, a first decoding node performs decoding to obtain a chip identifier and a die identifier of the functional module to be accessed by using the first access request, that is, obtain sktid and dieid.

In addition, if the first die determines that the first address information is within an address range of shared address space in the first die, the first decoding node may also perform decoding to obtain complete tgtid of the functional module to be accessed by using the first access request, that is, obtain sktid, dieid, and portid. However, a decoding node at a cross-die interface should ensure that tgtid remains unchanged after decoding again.

Optionally, step 701 may include: When the first die determines that the first address information is within an address range of the address space information of the another die, the first die determines that the first access request is not used to access the first die.

In another example, for the another die, for example, DIE1, the first address space information includes a base address Addr_DIE1 of DIE1, and it is assumed that an address space size of DIE1 is 4 G. In this case, address space corresponding to DIE1 is address space starting from Addr_DIE1 and having a size of 4 G. If the first address information is within an address range of address space information of DIE1, it may be considered that the first access request is used to access DIE1, and the first access request is sent to DIE1.

Optionally, step 701 may also include: When the first die determines that the first address information is within an address range of the address space information of the functional module in the first die, the first die determines that the first access request is used to access the first die.

In an example, for a functional module A in the first die, the first address space information includes a base address Addr_A of the functional module A, and it is assumed that an address space size of the functional module A is 2 G. In this case, address space corresponding to the functional module A is address space starting from Addr_A and having a size of 2 G. If the first address information is within an address range of address space information of the functional module A in the first die, it may be considered that the first access request is used to access the functional module A.

An embodiment of this application provides another decoding method applied to the chip system shown in FIG. 6. The decoding method is applied to a second die. FIG. 10 is a flowchart of another decoding method according to an embodiment of this application. The decoding method includes the following procedure.

Step 1001: A second die receives a second access request sent by a first die, where the second access request includes first address information and a die identifier obtained by the first die through decoding.

For example, the first die and the second die are coupled through a cross-die interface, and the second die receives, through the cross-die interface, the second access request sent by the first die. The second access request carries the first address information and the die identifier obtained by the first die through decoding.

Step 1002: When the second die determines that the die identifier is a die identifier of the second die, the second die performs decoding based on the first address information to obtain a module identifier of a functional module, in the second die, to be accessed by using the second access request.

For example, a second decoding node is provided at the cross-die interface between the second die and the first die, and the second decoding node is configured with address space information of each functional module in the second die. If the die identifier is the die identifier of the second die, the second access request is used to access the functional module in the second die. The second decoding node performs decoding based on the first address information to obtain the module identifier of the functional module, in the second die, to be accessed by using the second access request.

FIG. 11 is a flowchart of processing an access request by a second die according to an embodiment of this application. If a second access request is received at a cross-die interface of the second die, it is determined whether the second access request is an access request for the current die. If the second access request is an access request for the current die, a second decoding node performs decoding to obtain a module identifier of a functional module to be accessed by using the second access request, and aggregates the second access request onto a bus of the second die to send the second access request to the functional module to be accessed by using the second access request. If the second access request is not an access request for the current die, the second access request is aggregated onto a bus and sent to a cross-die interface between the second die and another die.

Step 1003: When the second die determines that the die identifier is not a die identifier of the second die, the second die transmits the second access request to a third die.

In an example, it is assumed that the chip system includes the first die, the second die, and the third die, where the first die and the second die are coupled through the cross-die interface, and the second die and the third die are coupled through a cross-die interface. If the second die determines that the die identifier is not the die identifier of the second die, that a functional module in the first die accesses a functional module in the third die is used as an example. The second die receives the second access request, and determines that the second access request is not an access request for the current die. A second decoding node at the cross-die interface of the second die does not decode the first address information carried in the second access request. That is, the second decoding node transparently transmits the second access request. The second access request is aggregated onto a bus and sent to the cross-die interface between the second die and the third die. The third die determines that the die identifier is a die identifier of the third die. A decoding node at a cross-die interface of the third die decodes the first address information carried in the second access request, to obtain a module identifier of a functional module, in the third die, to be accessed by using the second access request.

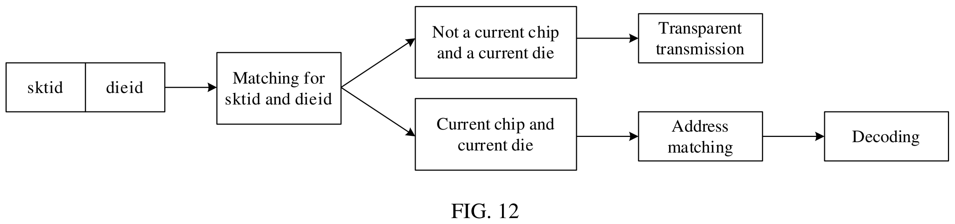

FIG. 12 is another flowchart of processing an access request by a second die according to an embodiment of this application. A second access request is received at a cross-die interface of the second die, where the second access request carries a chip identifier of the second die and a die identifier of the second die. That is, the second access request carries sktid and dieid. The second die performs matching for sktid and dieid. If sktid and dieid are not a current chip and the current die, the second access request is transparently transmitted. That is, the second access request is transmitted to a cross-die interface between the second die and another die through a bus. "Not a current chip and the current die" includes a case of not the current chip or the current die, and a case of the current chip but not the current die. If sktid and dieid are the current chip and the current die, a second decoding node performs address matching based on first address information, and performs decoding to obtain a module identifier of a functional module, in the second die, to be accessed by using the second access request.

Optionally, the second die includes a plurality of functional modules, the second die is configured with second address space information, and the second address space information includes address space information of each functional module in the second die and address space information of the another die other than the second die. The address space information of each functional module in the second die includes a base address of each functional module in the second die and an address space size of each functional module in the second die, and the address space information of the another die includes a base address of the another die and an address space size of the another die.

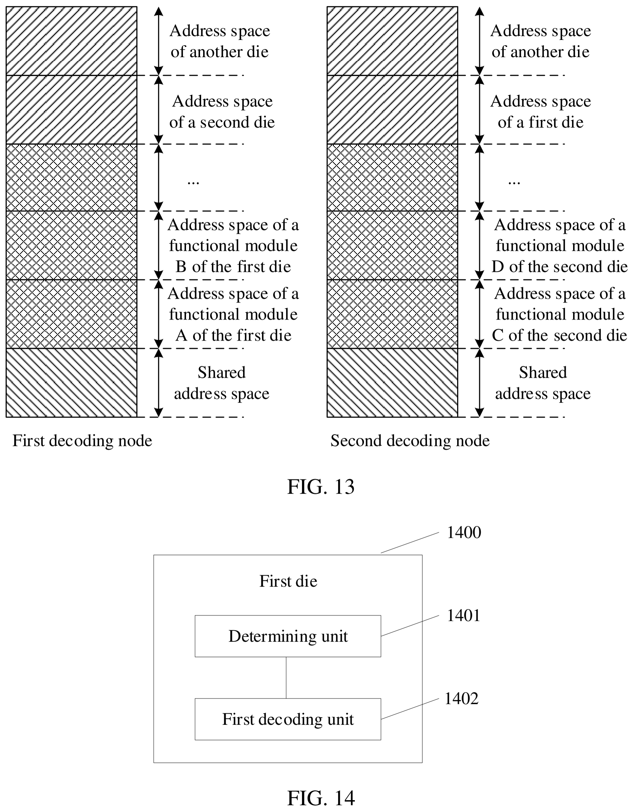

For example, the second die may include the second decoding node, and the second decoding node is configured with the second address space information. The second decoding node may also be implemented by using hardware. For example, the second decoding node may be a group of logic circuits with multi-input and multi-output. It is assumed that a first die includes a first decoding node, and the second die includes the second decoding node. The first decoding node or the second decoding node may be a decoding node between a functional module and a bus, or the first decoding node or the second decoding node may be a decoding node between a bus and a cross-die interface. In an example, FIG. 13 is a diagram of address space configuration of a first decoding node and a second decoding node according to an embodiment of this application. Each segment of address space corresponds to one decoding window. Shared address space is address space for storing a functional module shared by each die due to a configuration requirement of a chip system. That is, the first decoding node and the second decoding node are both configured with shared address space. The first decoding node is further configured with address space of a functional module A of a first die, address space of a functional module B of the first die, and address space of a second die. The second decoding node is further configured with address space of a functional module C of the second die, address space of a functional module D of the second die, and address space of the first die.

It can be seen that, either the first decoding node or the second decoding node is only configured with address space of functional modules in the current die and address space of another die without configuration of address space of a functional module in the another die, so that configuration information of the decoding node can be reduced, and a circuit area occupied by the decoding node can be reduced.

In general, the foregoing address space configuration is applied to the chip system shown in FIG. 6, where the first die is DIE1, and the second die is DIE0. For example, a functional module D requests to access a functional module A. The functional module D sends a first access request carrying first address information of the functional module A. DIE1 first determines whether the first access request is a request used to access a functional module in DIE1. Because the first access request is used to access the functional module A in DIE0, the first decoding node may perform decoding based on the first address information to obtain a die identifier of DIE0. The first decoding node sends the second access request to a cross-die interface between DIEO and DIE1 through a bus in DIE1. In this case, the second access request carries the first address information of the functional module A and the die identifier of DIE0. DIEO determines that the die identifier carried in the second access request is the die identifier of DIE0, and the second decoding node performs decoding based on the first address information to obtain a module identifier of the functional module A in DIE0. Therefore, DIEO sends the second access request to the functional module A through a bus in DIE0. After receiving the second access request, the functional module A returns a response or data, to complete a procedure of accessing the functional module A by the functional module D.

In addition, if the functional module A requests to access the functional module D, a third decoding node performs same processing as the first decoding node, and a fourth decoding node performs same processing as the second decoding node. Details are not described herein again.

Therefore, in the decoding method provided in embodiments of this application, through hierarchical decoding, configuration information of a decoding node is reduced, and decoding complexity is reduced. In addition, during design of dies such as a first die and a second die, limited windows are reserved for cross-die interconnection, without a need to pay attention to an internal topological interface of a die connected to a cross-die interface, to simplify a design requirement for multi-die interconnection, and implement flexible extension of decoding in any multi-die interconnection structure. In addition, for different connected dies, there is also no need to design different decoding principles, so that feasibility of die sharing is ensured.

It may be understood that, to implement the foregoing functions, an electronic device includes a corresponding hardware and/or software module for performing each function. With reference to algorithm steps of examples described in embodiments disclosed in this specification, this application can be implemented in a form of hardware or a combination of hardware and computer software. Whether a function is performed by hardware or hardware driven by computer software depends on particular applications and design constraints of the technical solutions. A person skilled in the art may use different methods to implement the described functions for each specific application with reference to embodiments. However, it should not be considered that the implementation goes beyond the scope of this application.

In this embodiment, the electronic device may be divided into functional modules based on the foregoing method examples. For example, each functional module is obtained through division corresponding to each function, or two or more functions may be integrated into one processing module. The integrated module may be implemented in a form of hardware. It should be noted that, in embodiments, division into modules is an example, and is merely logical function division. During actual implementation, another division manner may be used.

In an example, the electronic device may include a first die and a second die.

When each functional module is obtained through division corresponding to each function, FIG. 14 is a possible composition diagram of a first die 1400 in the foregoing embodiment. As shown in FIG. 14, the first die 1400 may include a determining unit 1401 and a first decoding unit 1402.

The determining unit 1401 may be configured by the first die 1400 to perform step 701 and the like, and/or configured to perform other processes of the technology described in this specification.

The first decoding unit 1402 may be configured to support the first die 1400 in performing step 702, step 703, and the like, and/or configured to perform other processes of the technology described in this specification.

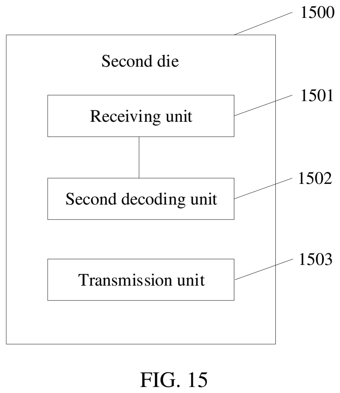

When each functional module is obtained through division corresponding to each function, FIG. 15 is a possible composition diagram of a second die 1500 in the foregoing embodiment. As shown in FIG. 15, the second die 1500 may include a receiving unit 1501, a second decoding unit 1502, and a transmission unit 1503.

The receiving unit 1501 may be configured by the second die 1500 to perform step 1001 and the like, and/or configured to perform other processes of the technology described in this specification.

The second decoding unit 1502 may be configured to support the second die 1500 in performing step 1002 and the like, and/or configured to perform other processes of the technology described in this specification.

The transmission unit 1503 may be configured to support the second die 1500 in performing step 1003 and the like, and/or configured to perform other processes of the technology described in this specification.

It should be noted that all related content of the steps in the foregoing method embodiments may be cited in function description of corresponding functional modules. Details are not described herein again.

The first die 1400 and the second die 1500 provided in embodiments are configured to perform the foregoing decoding method, and therefore effects the same as those of the foregoing implementation method can be achieved.

When an integrated unit is used, the electronic device may include a processing module, a storage module, and a communication module. The processing module may be configured to control and manage actions of the electronic device, for example, may be configured to support the electronic device in performing the steps performed by the determining unit 1401 and the first decoding unit 1402. The processing module may also be configured to support the electronic device in performing the steps performed by the receiving unit 1501 and the second decoding unit 1502. The storage module may be configured to support the electronic device to store program code, data, and the like. The communication module may be configured to support the electronic device in communicating with another device, for example, a wireless access device.

The processing module may be a processor or a controller. The processing module may implement or execute various example logical blocks, modules, and circuits described with reference to content disclosed in this application. The processor may alternatively be a combination for implementing a computing function, for example, a combination including one or more microprocessors or a combination of digital signal processing (digital signal processing, DSP) and a microprocessor. The storage module may be a memory. The communication module may be specifically a device that interacts with another electronic device, such as a radio frequency circuit, a Bluetooth chip, or a Wi-Fi chip.

In an embodiment, when the processing module is a processor and the storage module is a memory, the electronic device in this embodiment may be a chip system that is of the structure shown in FIG. 6.

An embodiment of this application further provides an electronic device, including one or more processors and one or more memories. The one or more memories are coupled to the one or more processors. The one or more memories are configured to store computer program code, and the computer program code includes computer instructions. When the one or more processors execute the computer instructions, the electronic device is enabled to perform the foregoing related method steps, to implement the decoding method in the foregoing embodiments.

An embodiment of this application further provides a computer storage medium. The computer storage medium stores computer instructions. When the computer instructions are run on an electronic device, the electronic device is enabled to perform the related method steps, to implement the decoding method in the foregoing embodiments.

An embodiment of this application further provides a computer program product. When the computer program product runs on a computer, the computer is enabled to perform the foregoing related steps, to implement the decoding method performed by the electronic device in the foregoing embodiments.

In addition, an embodiment of this application further provides an apparatus. The apparatus may be specifically a chip, a component, or a module. The apparatus may include a processor and a memory that are connected. The memory is configured to store computer-executable instructions. When the apparatus runs, the processor may execute the computer-executable instructions stored in the memory, so that the chip performs the decoding method performed by the electronic device in the foregoing method embodiments.

The electronic device, the computer storage medium, the computer program product, or the chip provided in embodiments is configured to perform the corresponding method provided above. Therefore, for benefit effects that can be achieved by the electronic device, the computer storage medium, the computer program product, or the chip, refer to the benefit effects of the corresponding method provided above. Details are not described herein again.

Based on the descriptions about the foregoing implementations, a person skilled in the art may understand that, for a purpose of convenient and brief description, division into the foregoing functional modules is used as an example for illustration. In actual application, the foregoing functions may be allocated to different functional modules and implemented according to a requirement. In other words, an inner structure of an apparatus is divided into different functional modules to implement all or some of the functions described above.

In the several embodiments provided in this application, it should be understood that the disclosed apparatus and method may be implemented in other manners. For example, the described apparatus embodiment is merely an example. For example, the module or division into the units is merely logical function division and may be other division in actual implementation. For example, a plurality of units or components may be combined or integrated into another apparatus, or some features may be ignored or not performed. In addition, the displayed or discussed mutual couplings or direct couplings or communication connections may be implemented through some interfaces. The indirect couplings or communication connections between the apparatuses or units may be implemented in electrical, mechanical, or another form.

The units described as separate parts may or may not be physically separate, and parts displayed as units may be one or more physical units, may be located in one place, or may be distributed on different places. Some or all of the units may be selected according to actual requirements to achieve the objectives of the solutions of embodiments.

In addition, functional units in embodiments of this application may be integrated into one processing unit, each of the units may exist alone physically, or two or more units may be integrated into one unit. The integrated unit may be implemented in a form of hardware, or may be implemented in a form of software functional unit.

When the integrated unit is implemented in the form of software functional unit and sold or used as an independent product, the integrated unit may be stored in a readable storage medium. Based on such an understanding, the technical solutions of embodiments of this application essentially, or the part contributing to the conventional technology, or all or some of the technical solutions may be implemented in the form of a software product. The software product is stored in a storage medium and includes several instructions for instructing a device (which may be a single-chip microcomputer, a chip or the like) or a processor (processor) to perform all or some of the steps of the methods described in embodiments of this application. The storage medium includes various media that can store program code, such as a USB flash drive, a removable hard disk, a read-only memory (read-only memory, ROM), a random access memory (random access memory, RAM), a magnetic disk, or an optical disc.

The foregoing descriptions are merely specific implementations of this application, but are not intended to limit the protection scope of this application. Any variation or replacement readily figured out by a person skilled in the art in the technical scope disclosed in this application shall fall within the protection scope of this application. Therefore, the protection scope of this application shall be subject to the protection scope of the claims.

## Claims

1. A decoding method, wherein the decoding method is applied to a first die, the first die comprises a plurality of functional modules, the first die is configured with first address space information, the first address space information comprises address space information of each functional module in the first die and address space information of another die other than the first die, and the method comprises:
determining, by the first die based on the first address space information and first address information carried in a first access request, whether the first access request is used to access the first die; and
if the first die determines that the first access request is not used to access the first die, performing, by the first die, decoding based on the first address information to obtain a die identifier of a second die, and sending a second access request to the second die, wherein the second access request comprises the first address information and the die identifier of the second die, and the second access request is used for decoding by the second die to obtain a module identifier of a functional module, in the second die, to be accessed by using the first access request.

2. The method according to claim 1, wherein the method further comprises:
if the first die determines that the first access request is used to access the first die, performing, by the first die, decoding based on the first address information to obtain a module identifier of a functional module, in the first die, to be accessed by using the first access request.

3. The method according to claim 1 or 2, wherein the address space information of each functional module in the first die comprises a base address of each functional module in the first die and an address space size of each functional module in the first die, and the address space information of the another die comprises a base address of the another die and an address space size of the another die.

4. The method according to claim 1 or 2, wherein the first address information is used for decoding to obtain a chip identifier, a die identifier, and the module identifier that correspond to the functional module to be accessed by using the first access request.

5. The method according to claim 1, wherein determining, by the first die based on the first address space information and the first address information carried in the first access request, whether the first access request is used to access the first die comprises:
when the first die determines that the first address information is within an address range of the address space information of the another die, determining, by the first die, that the first access request is not used to access the first die; or
when the first die determines that the first address information is within an address range of the address space information of the functional module in the first die, determining, by the first die, that the first access request is used to access the first die.

6. A decoding method, wherein the decoding method is applied to a second die, and the method comprises:
receiving, by the second die, a second access request sent by a first die, wherein the second access request comprises first address information and a die identifier obtained by the first die through decoding; and
when the second die determines that the die identifier is a die identifier of the second die, performing, by the second die, decoding based on the first address information to obtain a module identifier of a functional module, in the second die, to be accessed by using the second access request.

7. The method according to claim 6, wherein the method further comprises:
when the second die determines that the die identifier is not the die identifier of the second die, transmitting, by the second die, the second access request to a third die.

8. The method according to claim 6 or 7, wherein the second die comprises a plurality of functional modules, the second die is configured with second address space information, and the second address space information comprises address space information of each functional module in the second die and address space information of another die other than the second die.

9. The method according to claim 8, wherein the address space information of each functional module in the second die comprises a base address of each functional module in the second die and an address space size of each functional module in the second die, and the address space information of the another die comprises a base address of the another die and an address space size of the another die.

10. A first die, wherein the first die comprises a plurality of functional modules, the first die is configured with first address space information, the first address space information comprises address space information of each functional module in the first die and address space information of another die other than the first die, and the first die further comprises:
a determining unit, configured to determine, based on the first address space information and first address information carried in a first access request, whether the first access request is used to access the first die; and
a first decoding unit, configured to: if the first die determines that the first access request is not used to access the first die, perform decoding based on the first address information to obtain a die identifier of a second die; and send a second access request to the second die, wherein the second access request comprises the first address information and the die identifier of the second die, and the second access request is used for decoding by the second die to obtain a module identifier of a functional module, in the second die, to be accessed by using the first access request.

11. The first die according to claim 10, wherein the first decoding unit is further configured by the first die to: if the first die determines that the first access request is used to access the first die, perform decoding based on the first address information to obtain a module identifier of a functional module, in the first die, to be accessed by using the first access request.

12. The first die according to claim 10 or 11, wherein the address space information of each functional module in the first die comprises a base address of each functional module in the first die and an address space size of each functional module in the first die, and the address space information of the another die comprises a base address of the another die and an address space size of the another die.

13. The first die according to claim 10 or 11, wherein the first address information is used for decoding to obtain a chip identifier, a die identifier, and the module identifier that correspond to the functional module to be accessed by using the first access request.

14. The first die according to claim 10, wherein the determining unit is further configured to: when the first die determines that the first address information is within an address range of the address space information of the another die, determine that the first access request is not used to access the first die; or
when the first die determines that the first address information is within an address range of the address space information of the functional module in the first die, determine that the first access request is used to access the first die.

15. A second die, wherein the second die comprises:
a receiving unit, configured to receive a second access request sent by a first die, wherein the second access request comprises first address information and a die identifier obtained by the first die through decoding; and
a second decoding unit, configured to: when the second die determines that the die identifier is a die identifier of the second die, perform decoding based on the first address information to obtain a module identifier of a functional module, in the second die, to be accessed by using the second access request.

16. The second die according to claim 15, wherein the second die further comprises:
a transmission unit, configured to: when the second die determines that the die identifier is not the die identifier of the second die, transmit the second access request to a third die.

17. The second die according to claim 15 or 16, wherein the second die comprises a plurality of functional modules, the second die is configured with second address space information, and the second address space information comprises address space information of each functional module in the second die and address space information of another die other than the second die.

18. The second die according to claim 17, wherein the address space information of each functional module in the second die comprises a base address of each functional module in the second die and an address space size of each functional module in the second die, and the address space information of the another die comprises a base address of the another die and an address space size of the another die.

19. A computer-readable storage medium, comprising computer instructions, wherein when the computer instructions are run on an electronic device, the electronic device is enabled to perform the method according to any one of claims 1 to 9.

20. A computer program product, wherein when the computer program product runs on a computer or a processor, the computer or the processor is enabled to perform the method according to any one of claims 1 to 9.
